**Europäisches Patentamt**

**European Patent Office**

**Office européen des brevets**

(11) Veröffentlichungsnummer: **0 011 593**
**A1**

## (12) EUROPÄISCHE PATENTANMELDUNG

(21) Anmeldenummer: **79730007.6**

(22) Anmeldetag: **20.11.79**

(51) Int. Cl.³: **H 04 L 13/16**
**H 03 J 9/00**

(30) Priorität: **21.11.78 DE 2850974**

(43) Veröffentlichungstag der Anmeldung:
**28.05.80 Patentblatt 80/11**

(84) Benannte Vertragsstaaten:
**AT BE CH DE FR GB IT LU NL SE**

(71) Anmelder: **Heinrich-Hertz-Institut für Nachrichtentechnik Berlin GmbH**
**Einsteinufer 37**
**D-1000 Berlin 10(DE)**

(72) Erfinder: **Beldie, Ion-Paul, Dr.**
**Mommsenstrasse 23**
**D-1000 Berlin 12(DE)**

(72) Erfinder: **Gold, Herbert**
**Jahnstrasse 13**
**D-1000 Berlin 61(DE)**

(72) Erfinder: **Günther, Peter**
**Münchener Strasse 9**
**D-1000 Berlin 30(DE)**

(72) Erfinder: **Hunger, Jürgen**
**Naumannstrasse 60**
**D-1000 Berlin 62(DE)**

(72) Erfinder: **Mahnkopf, Peter**
**Spenerstrasse 11**
**D-1000 Berlin 21(DE)**

(72) Erfinder: **Mühlbach, Lothar**
**Kottbusser Damm 23**
**D-1000 Berlin 61(DE)**

(74) Vertreter: **Wolff, Konrad**
**Einsteinufer 37**
**D-1000 Berlin 10(DE)**

(54) **Bediengeräteanordnung mit Tastaturen für Verteil- und Dialogdienste.**

(57) Die Anordnung der Bediengeräte mit den Tastaturen für elektronisch steuerbare und für Verteil- und Dialogdienste eingerichtete Fernsehapparate besteht aus einem Handapparat und einem Tischgerät. Der Handapparat enthält im Tastenfeld (A) die Griffteile für Grundfunktionen und kann auf seiner gegenüberliegenden Fläche ein zweites Tastenfeld mit den Griffteilen für Kommandofunktionen besitzen, die sich in gleicher Gestaltung im rechten Teil der Tastatur (B) des Tischgerätes befinden. Den größten Anteil der Tastatur (B) des Tischgerätes nehmen die Griffteile für alphanumerische Zeichen ein. Die übrigen Griffteile sind für Editierfunktionen, Sonderzeichen und in der linken oberen Ecke für Umschaltfunktionen zu umfangreichen Dialogdiensten vorgesehen. Der Handapparat kann für Verteil- und einfache Dialogdienste allein benutzt werden. Das Tischgerät ist nur zusammen mit dem angeschlossenen Handapparat betriebsfähig. Funktionsmäßig zusammengehörige, insbesondere auf die Tastaturen (A) und (B) aufgeteilte Griffteile für Umschaltfunktionen, sind unter anthropotechnischen Gesichtspunkten zusammengefaßt, angeordnet und ausgeführt.

./...

Fig. 1

- 1 -

HEINRICH-HERTZ-INSTITUT FÜR NACHRICHTENTECHNIK BERLIN GMBH

1.10/78 EP

Bediengeräteanordnung mit Tastaturen für Verteil- und Dialogdienste

Die Erfindung bezieht sich auf eine Bediengeräteanordnung mit Tastaturen für elektronisch steuerbare und für Verteil- und Dialogdienste eingerichtete Fernsehapparate.

Außer den drahtlos oder auch über Kabel übertragenen reinen Verteildiensten, also der Versorgung der Teilnehmer mit regionalen und überregionalen Fernsehprogrammen sowie neuerdings mit weiteren Informationsdiensten wie Bildschirmtext, Videotext usw., ergeben sich im Zusammenhang mit dem weiteren Ausbau von Kabelfernsehanlagen und einer vergrößerten Kapazität an Rückkanälen Möglichkeiten für erweiterte Dialogdienste, bei denen Teilnehmer untereinander sowie über eine oder mit einer Zentrale Informationen austauschen, die sich aus alphanumerischen Zeichen zusammensetzen.

Aus dem Jahresbericht (1976 Annual Report) der Warner Communications Inc. - USA - geht auf S. 45 hervor, daß dort die an Kabelfernsehnetze angeschlossenen Teilnehmer über Tastenapparate verfügen, mit denen durch Betätigung von jeweils zwei Tasten eines Zehner- und eines Dreier-Satzes einer von dreißig Kanälen für allgemeine und individuelle Verteildienste ausgewählt werden kann. Außerdem ist ein Satz mit weiteren fünf Tasten vorgesehen, deren Funktionen jedoch nicht näher erläutert sind. Bei diesem Tastenapparat soll es sich um ein Fabrikat der Firma Pioneer Electronic Corp. Tokio, Japan handeln.

Außerdem sind in der Unterhaltungselektronik - ohne daß es eines druckschriftlichen Nachweises bedarf - Fernsteuerungen für z.B. Fernsehgeräte bekannt, die mit mehreren Tasten bzw. Tastern für die Auswahl des Senders (Programm) und die Einstellung der Lautstärke, der Helligkeit und der Farbsättigung ausgerüstet sind.

Diese bekannten Bediengeräte reichen für die oben erwähnten erweiterten Dialogdienste nicht aus, wobei es insbesondere als sehr nachteilig empfunden werden würde, wenn auch alphanumerische Zeichen, wie diese z.B. bei Schreibmaschinentastaturen einschließlich der Umschaltung zwischen Klein- und Großschreibung mit ca. fünfzig Tasten realisiert werden, nur durch Betätigen von jeweils zwei oder mehreren Tasten einer Matrix mit insgesamt z.B. dreizehn oder fünfzehn Tasten abgegeben werden könnten.

Die der Erfindung zugrundeliegende Aufgabenstellung besteht nun darin, eine benutzerfreundliche Bediengeräteanordnung zu schaffen, mit der sowohl die von Schreibmaschinen her bekannte und gebräuchliche Tastatur für alphanumerische Zeichen als auch an sich bekannte Handapparate für die Ein-/Aus- und Umschaltung und die Regelung der Grundfunktionen von Fernsehapparaten zum Einsatz kommen können. Da diese Grundfunktionen sowohl bei einfachen als auch bei erweiterten Dialogdiensten benötigt werden, soll darüber hinaus die Tastatur mit den alphanumerischen Zeichen nur zusammen mit dem Gerät für die Grundfunktionen in Betrieb zu nehmen sein. Gemäß der Erfindung ist eine derartige Bediengeräteanordnung gekennzeichnet durch

- eine funktionsmäßige Aufteilung der Tastaturen auf
- ein Tischgerät mit den für Dialogdienste benötigten alphanumerischen Zeichengebern

und auf

- einen Handapparat für die Einstellung und Regelung der Grundfunktionen des Fernsehapparates,
- die Anordnung des Sendeteiles für die Übertragung der Signale von den Bediengeräten (Tischgerät und Handapparat) zum Fernsehapparat, im Handapparat und durch
- eine Steckverbindung für den lösbaren Anschluß des Handapparates an das Tischgerät.

Die Größe des Handapparates findet eine anthropotechnische Grenze bei einer großen Quaderfläche von etwa 7 cm x 15 cm und einer Höhe von etwa 2 cm bis 5 cm. Ein auf einer großen Quaderfläche befindliches Tastenfeld kann dabei mit ca. zwanzig bis vierzig Griffteilen, z.B. Knöpfen, Drückern, Schiebern, Hebeln, Sensortasten oder dergleichen bestückt sein. Diese Größe reicht damit aus, um z.B. zwölf oder sechzehn Tasten für die Sender- bzw. Programmwahl und die anderen manuell zu betätigenden Griffteile für die übrigen Gerätefunktion (Bildhelligkeit, Farbsättigung, Lautstärke) ohne Doppel- bzw. Mehrfachbelegung unterzubringen.

Das Tischgerät besitzt dagegen allein für die alphanumerische Tastatur schon mindestens die doppelte Größe. Es bleibt dabei jedoch noch immer klein und leicht genug, um auch zusammen mit dem angesteckten Handapparat aufgenommen und beispielsweise vom sitzenden Teilnehmer auf dem Schoß gehalten werden zu können.

Ein wesentlicher Vorteil der erfindungsgemäßen Bediengeräteanordnung liegt darin, daß für reine Verteildienste, also insbesondere herkömmliche Fernsehprogramme, der Handapparat allein und losgelöst vom Tischgerät benutzt werden kann. In ihm ist der Sendeteil für die Signale, die von ihm selbst und auch vom Tischgerät zum Fernsehapparat zu übertragen sind, enthalten. Das bedeutet, das Tischgerät kann nur zusammen mit dem angesteckten Handapparat, der Handapparat aber auch ohne das Tischgerät - dann selbstverständlich nur für Dienste ohne Alphanumerik - in Betrieb genommen werden.

Die Steckverbindung für den lösbaren Anschluß des Handapparates an das Tischgerät muß so ausgebildet sein, daß nicht nur eine Verbindung von den Schalteinrichtungen des Tischgerätes zum Sendeteil für die Übertragung der Signale hergestellt, sondern auch eine den mechanischen Beanspruchungen standhaltende Halterung des Handapparates am Tischgerät herbeigeführt wird.

Im Zusammenhang mit einem älteren Vorschlag - DE - OS .. .. ... (P 28 27 075.9)- ergibt sich eine besonders vorteilhafte Ausführungsform der Erfindung, bei der zwei gleich gestaltete Tastaturfelder für Kommandofunktionen vorgesehen sind, von denen sich das eine im Tischgerät und das andere im Handapparat - in Form einer Wende-Tastatur - befindet. Diese Kommandofunktionen werden nämlich sowohl bei einfachen als auch erweiterten Dialogdiensten benötigt und dienen z.B. zum Verschieben einer Lichtmarke (Cursor) auf dem Bildschirm des Fernsehgerätes. Für einfache Dialogdienste - ohne Alphanumerik - kann auch hier der Handapparat ortsunabhängig, d.h. von beliebiger Stelle im Raum, in dem der Fernsehapparat aufgestellt ist, und ohne das Tischgerät benutzt werden. Im an das Tischgerät angeschlossenen Zustand befindet sich diese Tastatur beim Handapparat dann allerdings auf der Unterseite und kann deshalb in dieser Lage nicht verwendet werden. Dafür kommt dann die zweite gleichgestaltete Tastatur im Tischgerät zum Einsatz, wobei sich aufgrund der gleichen Gestaltung auch keine Schwierigkeiten bei der Bedienung ergeben.

Im Hinblick auf die Benutzerfreundlichkeit der Bediengeräteanordnung ergibt sich eine weitere vorteilhafte Ausführungsform der Erfindung mit sich für Umschaltfunktionen im zusammengesteckten Zustand des Handapparates und des Tischgerätes in einer Reihe befindlichen Tasten, die für die Umschaltung von Grundfunktionen, z.B. "Aus", "Bildschirmtext", "Videotext", "Fernsehen" im Tastenfeld des Handapparates und für die Umschaltung auf Zweiwegkabelfernsehen und die Initialisierungsfunktion im Tastenfeld des Tischgerätes vorgesehen sind. Diese, auf beide Geräte aufgeteilten Tasten bilden zusammen die Gruppe der Griffteile für die Umschaltfunktionen und bewirken durch ihre funktionsmäßige Aufteilung auf die entsprechenden Bediengeräte die Einhaltung einer Hierarchie bezüglich der Verteil- und einfachen sowie erweiterten Dialogdienste.

Wie bereits weiter oben schon erwähnt, kann der Handapparat allein und losgelöst vom Tischgerät für die Bedienung der einfacheren Dienste verwendet werden. In der Regel wird der Teilnehmer seinen Handapparat aber auch bei diesen Diensten häufig und insbesondere auch während der Betriebsruhe im zusammengesteckten Zustand mit dem Tischgerät belassen. Hierdurch sind die Voraussetzungen für eine bevorzugte Ausführungsform der Erfindung gegeben, bei der eine von einem im Tischgerät befindlichen Netzteil aufladbare Batterie im Handapparat zur Energieversorgung des Sendeteils vorgesehen ist. Selbstverständlich kann ohne Schwierigkeiten dafür gesorgt werden, daß im zusammengesteckten Zustand nicht nur eine Aufladung der Batterie stattfindet, sondern dann auch die Energieversorgung des Handapparates, insbesondere seines Sendeteils, durch das Netzgerät erfolgt, so daß bei ungenügend aufgeladener Batterie im Handapparat nicht etwa eine Einschaltung unmöglich wäre und nur auf die Flexibilität bezüglich der Ortsungebundenheit bei der Benutzung des Handapparates verzichtet werden muß. In diesem Zusammenhang sind auch solche Abänderungen zu sehen, bei denen für die gesamte Bediengeräteanordnung eine von diesen Geräten örtliche getrennte Aufladung oder eine Energieversorgung des einen Gerätes oder beider Geräte über auswechselbare Batterien erfolgt.

Erfahrungsgemäß wird bei einer drahtlosen Übertragung von Signalen von Bediengeräten zum elektronisch steuerbaren Apparat, insbesondere Fernsehapparat, die Möglichkeit, die Bedienung von wechselnden Stellen im Raum aus vorzunehmen, von vielen Teilnehmern nur in geringem Umfang genutzt. Da die Einrichtung eines Raumes ziemlich festliegt, d.h. der Fernsehapparat seinen Platz hat und nur von kaum verrückbaren Plätzen aus betrachtet wird, kann auch in vielen Fällen eine Kabelverbindung vom Bediengerät zum zu steuernden Gerät vorgesehen werden. Solche Kabelverbindungen werden insbesondere dann nicht als sonderlich nachteilig empfunden, wenn sich damit andere Vorteile ergeben. Sofern z.B. ein Anschluß zu einer Netzsteckdose vorhanden sein muß, also ohnehin ein Kabel mehr oder weniger lose durch einen Teil des Raumes führt, kann in vorteilhafter Weise für Ausführungsformen der Erfindung vorgesehen werden, beim Zusammenstecken des Handapparates mit dem Tischgerät selbsttätig von drahtloser Signalübertragung zum Fernsehapparat auf leitergebundene Signalübertragung umzuschalten. Eine mit der Steckverbindung zwischen Handapparat und Tischgerät zusammenwirkende Schalteinrichtung läßt sich dann in besonders einfacher Weise ausbilden, wenn diese Schalteinrichtung als Ein-/Aus-Schalter für die Spannungsversorgung der Tastaturkontakte im Tischgerät dient. Die durch Betätigung der Griffteile der Tastaturen für Alphanumerik, Kommandofunktionen, Umschaltfunktionen und Editierfunktionen abgegebenen Signale können dann in ihrer großen Zahl ohne besondere Maßnahmen unmittelbar dem zu steuernden Gerät zugeführt werden, wobei zugleich eine Niederspannungsversorgungsleitung im selben Kabel mitgeführt werden kann, sich also eine getrennte Netzanschlußleitung erübrigt.

Bei drahtloser Übertragung einer großen Zahl von Signalen ist dagegen eine Digitalisierung und Codierung dieser Signale in den Bediengeräten vorzunehmen, wobei darauf zu achten ist, daß sich beispielsweise Fernsteuerungen mittels Infrarot oder Ultraschall auch für andere Geräte wie Stereoanlagen oder dergleichen im selben Raum nicht gegenseitig beeinflussen.

In der Zeichnung sind Ausführungsformen der Erfindung schematisch dargestellt. Dabei zeigen:

> Fig. 1: die Tastenfelder einer Bediengeräteanordnung
> und Fig. 2: ein Ausführungsbeispiel mit einer Steckverbindung.

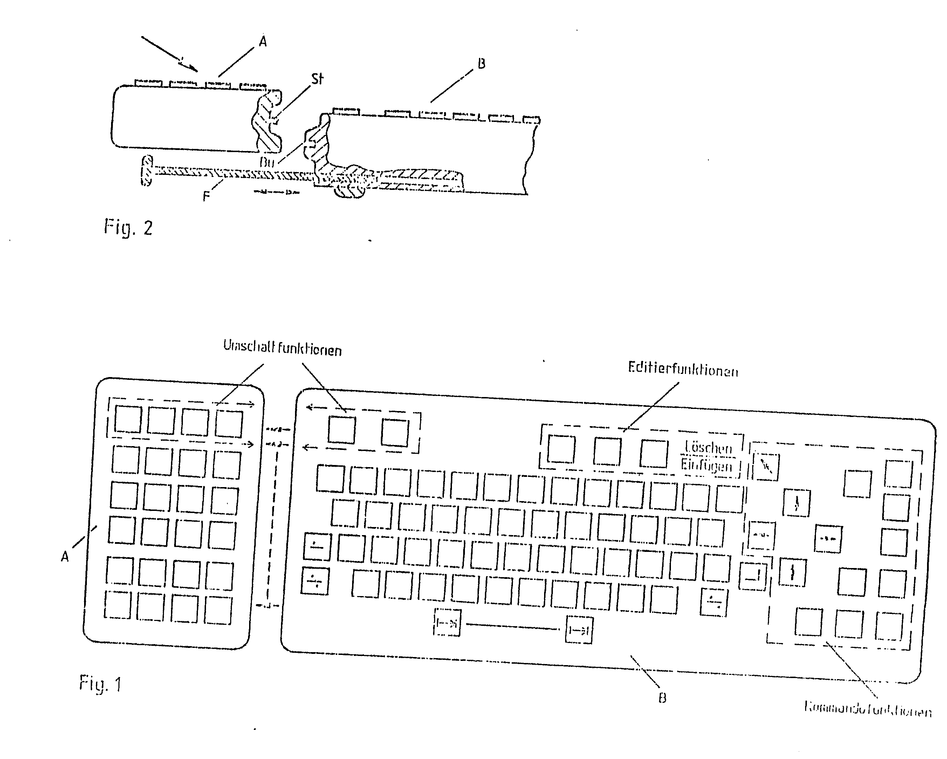

Im linken Teil der Fig. 1 ist das Tastenfeld A des Handapparates mit den Griffteilen für die Grundfunktionen dargestellt. Dabei handelt es sich in der oberen Reihe um vier Tasten für die Umschaltfunktionen "Aus", "Bildschirmtext -BT", "Video-Text -VT" und "Fernsehen -TV". Zu dieser Gruppe gehören noch die beiden Tasten "Zweiwegkabelfernsehen -ZKTV" und "Initialisierung -IT" im Tischgerät, die sich im zusammengesteckten Zustand von Handapparat und Tischgerät in einer Reihe befinden und einheitlich in einer Farbe, z.B. grau, gehalten sind.

Die in der Tastatur A in der zweiten, dritten und vierten Reihe von oben befindlichen zwölf Tasten tragen die Ziffern 1,2...9,0 sowie Stern * und Raute ÷ in Anlehnung an die Tastaturen bei Fernsprechgeräten. Diese Tasten dienen der Kanal- bzw. Programmwahl bei "TV" sowie dem Blättern bei "BT" oder "VT". Hier sind gegebenenfalls zwei oder mehrere Tasten, auch gleiche, nacheinander zu betätigen.

Die acht Tasten in den beiden unteren Reihen der Tastatur A des Handapparates dienen zur Einstellung der Bild- und Tonqualität und können teilweise - z.B. für "Laut-Leise", "Hell-Dunkel" auch als wippende Griffteile ausgebildet sein.

Im rechten Teil der Tastatur B des Tischgerätes befinden sich die Griffteile für Kommandofunktionen, die in gleicher Gestaltung auch als ein zweites Tastenfeld auf der Rückseite des Handapparates nach Art einer "Wendetastatur" vorgesehen sein kann. Aus der Bezeichnung der Tasten mit den Pfeilen für die Cursorverschiebung geht deren Bedeutung klar hervor und braucht deshalb hier nicht näher erläutert zu werden. Die anderen Tasten haben die Funktionen "Beratung", "Überblick", "Anfang", "Ende", "Weiter" und "Zurück" bzw. sind, soweit hier noch frei, farblich unterschiedlich und den gewünschten Erfordernissen entsprechend programmierbar.

Den größten Anteil der Tastatur B des Tischgerätes nehmen die Griffteile für die alphanumerischen Zeichen ein, deren Anordnung z.B. nach DIN 2137, Teil 1 erfolgt. Dazu gehören gegebenenfalls Sonderzeichen wie "größer->-" und "kleiner-<-" und die Tasten für die beiden Umschaltfunktionen und Umschalten-Ein-Funktion (shift lock).

Oberhalb dieser vier Reihen für die Alphanumerik und rechts von den beiden Griffteilen der Gruppe Umschaltfunktionen in der Tastatur B befinden sich drei Tasten für Editierfunktionen, mit denen bei Dialogdiensten "Zeichen", "Zeile" sowie "Bild" eingefügt bzw. gelöscht werden kann.

Um dem Benutzer die Zusammengehörigkeit der einzelnen Gruppen von Griffteilen auf beiden Tastaturen A und B leicht kenntlich zu machen, werden z.B. die Tasten für die Kommandofunktionen in blau, für die Editierfunktionen sowie für die Programm- bzw. Senderwahl in hellgrün und - wie bereits erwähnt - für die Umschaltfunktionen in grau gehalten.

In der Fig. 2 ist für den lösbaren Anschluß des **Handapparates** - mit dem Tastenfeld A - an das Tischgerät - mit dem **Tastenfeld B** - eine Ausführungsform dargestellt, bei der eine ausziehbare Ablage F vorgesehen ist, die den Handapparat nach dem Zusammenstecken trägt, ohne daß die Steckverbindung - Stecker St und Buchsen Bu - mecha-

nischen Belastungen ausgesetzt wird. Die Ablage F ist dabei so ausgebildet, daß der Handapparat an der dem Stecker gegenüberliegenden Schmalseite ein Widerlager findet, durch das zudem im eingeschobenen Zustand der Ablage F ein Zusammenstecken von Handapparat und Tischgerät verhindert wird.

- 1 -

HEINRICH-HERTZ-INSTITUT FÜR NACHRICHTENTECHNIK BERLIN GMBH

1.10/78 EP

Patentansprüche

1. Bediengeräteanordnung mit Tastaturen für elektronisch steuerbare und für Verteil- und Dialogdienste eingerichtete Fernsehapparate, gekennzeichnet durch

- eine funktionsmäßige Aufteilung der Tastaturen auf

  - ein Tischgerät mit den für Dialogdienste benötigten alphanumerischen Zeichengebern

  und auf

  - einen Handapparat für die Einstellung und Regelung der Grundfunktionen des Fernsehapparates,

- die Anordnung des Sendeteils für die Übertragung der Signale von den Bediengeräten (Tischgerät und Handapparat) zum Fernsehapparat im Handapparat

und durch

- eine Steckverbindung für den lösbaren Anschluß des Handapparates an das Tischgerät.

2. Bediengeräteanordnung nach Anspruch 1, gekennzeichnet durch zwei gleich gestaltete Tastenfelder für Kommandofunktionen, von denen das eine Tastenfeld im Tischgerät und das andere im Handapparat auf der - bei einer im wesentlichen quaderförmigen Gestalt des Handapparatgehäuses - großen Quaderfläche mit dem Tastenfeld für die Grundfunktionen gegenüberliegenden großen Quaderfläche vorgesehen ist.

3. Bediengeräteanordnung nach Anspruch 1 oder 2, gekennzeichnet durch sich im zusammengesteckten Zustand des Handapparates und des Tischgerätes in einer Reihe, für die Umschaltung von Grundfunktionen in der Tastatur des Handapparates und für die Umschaltung auf interaktiven Dienst in der Tastatur des Tischgerätes, befindliche Tasten.

- 2 -

4. Bediengeräteanordnung nach einem der Ansprüche 1 bis 3,
gekennzeichnet durch
eine von einem im Tischgerät befindlichen Netzteil aufladbare
Batterie im Handapparat zur Energieversorgung des Sendeteils.

5. Bediengeräteanordnung nach einem der Ansprüche 1 bis 4,
gekennzeichnet durch
eine beim Zusammenstecken des Handapparates mit dem Tischgerät
selbsttätig von drahtloser Signalübertragung zum Fernsehapparat
auf leitergebundene Signalübertragung umschaltende Einrichtung.

A  St  B

Bu

F

Fig. 2

Umschaltfunktionen

Editierfunktionen

Löschen
Einfügen

A

B

Kommandofunktionen

Fig. 1

0011593

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | ELEKTROTECHNIK UND MASCHINENBAU, Band 95, Nr. 8, August 1978, Wien, AT, H. HINTZ: "Teletext und Viewdata-neue Formen der Telekommunikation" Seiten 363-369<br><br>* Seite 367, Abbildung 13; Seite 368, linke Spalte, Zeilen 1-18; Abbildung 16 * | 1 |
| P | DE - A - 2 727 335 (BLUTHGEN) (21.12.1978)<br><br>* Seite 5, Zeilen 13-31 * | 1 |
| A | ELECTRONICS, Band 49, Nr. 10, 13. Mai 1976, New York, US, M. LORKOVIC: "MOS technology brings fun and games to tv sets", Seiten 87-92<br><br>* Seite 87, Absatz 6 * | 1,4 |

**KLASSIFIKATION DER ANMELDUNG (Int.Cl. 3)**

H 04 L 13/16
H 03 J 9/00

**RECHERCHIERTE SACHGEBIETE (Int. Cl. 3)**

H 04 L 13/00
H 03 J 9/00
H 04 N 7/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 14-02-1980 | DE ROECK |

EPA form 1503.1 06.78